# EUROPEAN PATENT APPLICATION

(11) **EP 4 592 749 A1**
(43) Date of publication of application: **30.07.2025**
(21) Application number: 24153301.7
(22) Date of filing: 23.01.2024
(51) Int. Cl.: G03F 7/00, G02B 5/09, G02B 26/08

(54) **LITHOGRAPHIC APPARATUS AND ASSOCIATED METHOD**

(71) Applicant: ASML Netherlands B.V., 5500 AH Veldhoven (NL)
(72) Inventor: GANG, Tian, 5500 AH Veldhoven (NL); FINDERS, Jozef, Maria, 5500 AH Veldhoven (NL); MCNAMARA, John, Martin, 5500 AH Veldhoven (NL); VAN DER LAAN, Hans, 5500 AH Veldhoven (NL); STEEGHS, Marco, Matheus, Louis, 5500 AH Veldhoven (NL); HAGEMAN, Joost, Cyrillus, Lambert, 5500 AH Veldhoven (NL); DE WINTER, Laurentius, Cornelius, 5500 AH Veldhoven (NL); IMPONENTE, Giovanni, 5500 AH Veldhoven (NL); FRISCO, Pierluigi, 5500 AH Veldhoven (NL); VAN SETTEN, Eelco, 5500 AH Veldhoven (NL); BILLER, Jan, 5500 AH Veldhoven (NL); DE JONG, Edwin, 5500 AH Veldhoven (NL); VAN DEN BROEKE, Jette, Janine, 5500 AH Veldhoven (NL); SCHOLZ, Christian, Oliver, 5500 AH Veldhoven (NL); VAN LEUKEN, Dirk, Petrus, Josephus, 5500 AH Veldhoven (NL); RIO, David, Marie, 5500 AH Veldhoven (NL); BRUNNER, Timothy, Allan, Wilton, CT 06897 (US); MITRIAS, Christos, 5500 AH Veldhoven (NL)
(74) Representative: ASML Netherlands B.V.

(57) **Abstract**

There is provided a method of configuring a lithographic apparatus comprising illuminator optics (10, 11) for directing at least a portion of a radiation beam to an illumination region (IR) of a patterning device so as to impart a pattern to the radiation beam and form a patterned radiation beam, the method comprising: configuring the illuminator optics such that at least two different portions of the patterning device (48, 50), differing at least in position along a scanning direction (y) of said illumination region, receive radiation from different regions (52, 54) of the illuminator optics within a pupil plane associated with the illuminator optics.

## Description

### FIELD

The present invention relates to a lithographic apparatus. The present invention also relates to a corresponding method of forming a pattern on a target region of a substrate. The lithographic apparatus and method may use extreme ultraviolet (EUV) radiation.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

It is desirable to provide control over various properties of a radiation beam that is used in a lithographic apparatus to project a pattern onto a substrate. For example, it is desirable to monitor an energy of the radiation beam to allow control over a dose of radiation that is delivered to the substrate. Furthermore, it is desirable to provide control over the shape (i.e. the spatial distribution) of the radiation beam in a plane of the patterning device. In addition, it is desirable to provide control over the angular distribution of the radiation beam in a plane of the patterning device. The angular distribution of the radiation beam in a plane of the patterning device may be referred to as an illumination mode this may be chosen in dependence on the pattern being imaged to increase image contrast on the substrate.

It may be desirable to provide new, alternative lithographic apparatus and/or methods that at least partially addresses one or more problems associated with prior art arrangements whether identified herein or otherwise.

### SUMMARY

In a first aspect there is provided a method of configuring a lithographic apparatus comprising illuminator optics for directing at least a portion of a radiation beam to an illumination region of a patterning device so as to impart a pattern to the radiation beam and form a patterned radiation beam, the method comprising: configuring the illuminator optics such that at least two different portions of the patterning device, differing at least in position along a scanning direction of said illumination region, receive radiation from different regions within a pupil plane associated with the illuminator optics.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2a schematically shows a generally circular portion of the field facet mirror device of the lithographic system shown in Figure 1, showing a central obscuration portion two portions which receive radiation;
- Figure 2b shows an example shape of a field facet for a faceted field mirror device in a known EUV lithographic apparatus of the form shown in Figure 1;
- Figures 3a and 3b show a simplified and schematic representation of a first optical element (or faceted pupil mirror device) that is not disposed in the entrance pupil of a projection system, or a plane conjugate thereto, and the projection (an annulus represented by dashed lines) of the entrance pupil of the projection system onto the first optical element for a first position in an illumination region (see Figure 3a) and a second position in the illumination region (see Figure 3b).
- Figure 4a shows an illumination mode for the first position in the illumination region (as shown in Figure 3a);
- Figure 4b shows an illumination mode for the second position in the illumination region (as shown in Figure 3b);
- Figure 5 is a schematic representation of an embodiment of an illumination system according to the present disclosure;
- Figure 6 is a schematic representation of an embodiment of an illumination system according to the present disclosure comprising a second optical element comprising a plurality of sets of focusing elements, each set of focusing elements arranged to direct radiation to a different one of a plurality of portions of an illumination region;
- Figure 7 is a plot of illumination intensity (I) vs. illumination region length in a scanning direction (y).
- Figure 8 is a schematic representation of an embodiment of an illumination system according to the present disclosure comprising a second optical element comprising a plurality of sets of focusing elements, each set of focusing elements arranged to direct radiation to a different one of a plurality of portions of an illumination region.
- Figures 9a and 9b are representations of a focus plane.
- Figure 10 is a schematic representation of overlay errors induced by a locally tilted wafer surface and a method to reduce the overlay errors.
- Figure 11 demonstrates the decomposition of a hexapole illumination mode into a dynamic illumination profile consisting of two rotated tri-pole illumination modes.
- Figure 12 demonstrates the decomposition of a hexapole illumination mode into three rotated dipole illumination modes.

### DETAILED DESCRIPTION

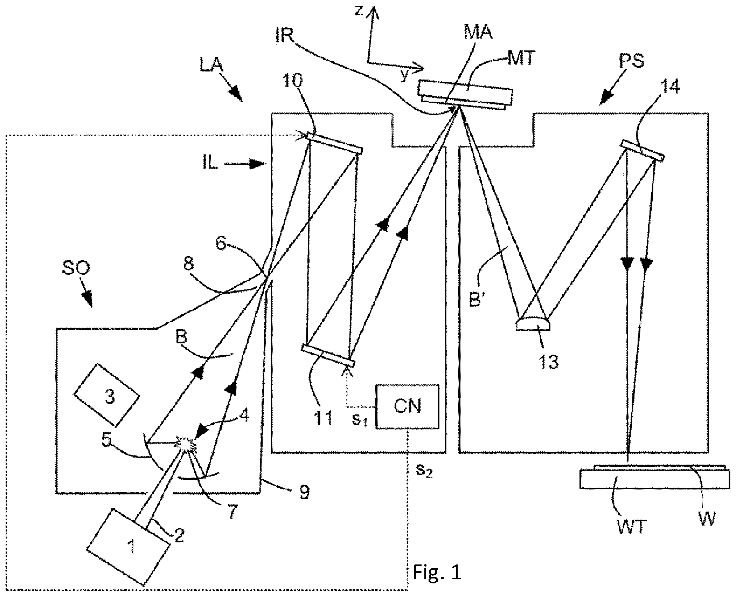

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

The lithographic apparatus LA further comprises a controller CN that is operable to control a configuration of the faceted field mirror device 10 and faceted pupil mirror device 11. To achieve this, the controller CN may be operable to send a suitable control signal s₁, s₂ to each of the faceted pupil mirror device 11 and the faceted field mirror device 10.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13, 14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13, 14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system 1, which may, for example, include a COz laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during de-excitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a discharge produced plasma (DPP) source or a free electron laser (FEL) may be used to generate EUV radiation.

The faceted field mirror device 10 and the faceted pupil mirror device 11 are arranged to provide a desired angular distribution of the radiation beam B, at the patterning device MA, as well as a desired uniformity of radiation intensity at the patterning device MA. The angular distribution of radiation at the patterning device MA may be referred to as the illumination mode. It may also be referred to as the pupil or pupil fill. The illumination system IL may be arranged to provide Kohler illumination of an illumination region IR (that the patterning device MA may be moved through during exposure of a substrate W) such that the plasma at the plasma formation region 4 is out of focus (and therefore does not influence properties of the radiation beam) at the patterning device MA and in the conjugate plane of the substrate W. As used herein, the illumination region IR may also be referred to as the illumination slit or the slit. Said illumination region may comprise the only region of the patterning device illuminated by said at least a portion of the EUV radiation beam B at any instance of time.

In lithography, the illumination of the patterning device MA is very important. In particular, it is desirable to control the angular distribution of the radiation at the illumination region IR where the patterning device MA is exposed to radiation. This angular distribution of the radiation is conveniently described in terms of the spatial distribution of the radiation in an illumination pupil plane, which describes how a cone of light that is incident on each point on the patterning device MA is filled. In a conventional illumination mode, the radiation uniformly fills a circular region of the illumination pupil plane centred on the optical axis such that each point on the patterning device is illuminated by a solid cone of light. In dipole illumination mode, the radiation fills two regions of the illumination pupil plane that are spaced apart from, and on opposite sides to, the optical axis. Many other illumination modes are known. In principle, an optimum illumination mode can be defined to image a given pattern under given conditions. Therefore, it is desirable to provide flexibility in the illumination mode.

The uniformity of the illumination is also very important. The uniformity of illumination affects the uniformity of dose to which the target portion of the substrate W is exposed, which affects critical dimension uniformity (CDU), an important measure of the uniformity of the dimension of features formed on the substrate W. For example, it may be desirable to maintain a desired spatial intensity distribution of radiation across the illumination region IR. As used herein the spatial intensity distribution of radiation across the illumination region IR may be referred to as the slit profile.

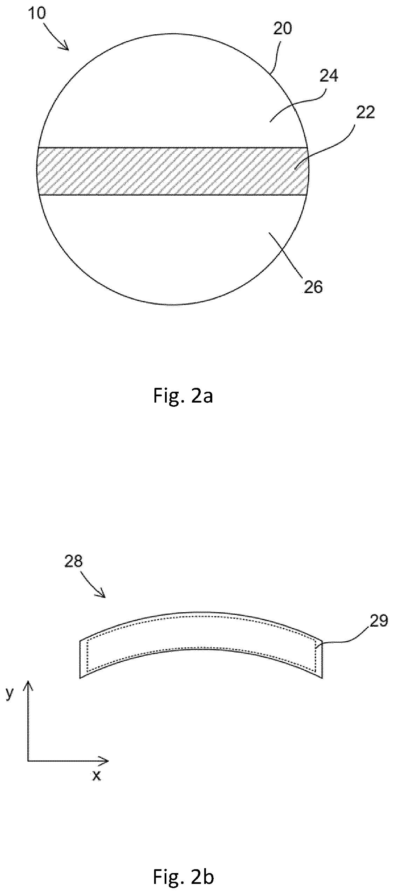

The collector 5 is generally of the form of a concave mirror, which is arranged to collect the radiation which is emitted from the plasma formation region 4 into a solid angle subtended by the collector 5. This radiation is reflected and focused at the intermediate focus 6. As a result, within the housing, the radiation beam B is generally of the form of a converging cone of radiation, which converges at the intermediate focus 6, an outer edge of this cone being indicated in Figure 1 by two lines. Downstream of the intermediate focus 6, the radiation beam B is generally of the form of a diverging cone of radiation, which is incident on the generally circular field facet mirror device 10. However, the radiation source SO may comprise an obscuration that will block a portion of this radiation cone such that there will be some portion of the diverging cone of radiation that which will not receive radiation from the collector 5. For example, the radiation source SO may comprise a shield (not shown) which may be arranged to prevent the laser beam 2 from propagating through the opening 8 and into the lithographic apparatus LA (where it may damage optical components). This shield may be supported by the enclosing structure via a support (not shown). Together, the shield and the support form an obscuration of the radiation source SO. Therefore, as indicated schematically in Figure 2a a generally circular portion 20 of the field facet mirror device 10 may comprise a central portion 22, which coincides with the obscuration of the radiation source SO and does not receive any radiation, and two portions 24, 26 which do receive radiation. It will be appreciated that this is schematic and that the obscuration may have any shape or configuration.

A known faceted field mirror device 10 used in an EUV lithographic apparatus of the type shown in Figure 1 is now described with reference to Figures 2a and 2b.

In known EUV lithographic apparatus, the faceted field mirror device 10 comprises a plurality of field facets. In particular, in such known EUV lithographic apparatus, the portions 24, 26 of the faceted field mirror device 10 that receive radiation from the radiation source SO are provided with a plurality of field facets. For example, the portions 24, 26 of the faceted field mirror device 10 that receive radiation from the radiation source SO may be provided with of the order of 100 field facets (for example 300 field facets). In a plane of the faceted field mirror device 10 each field facet may have a curved shape 28, as shown in Figure 2b. In general, in the plane of the faceted field mirror device 10 each field facet may have an elongate shape having a longer dimension in an x-direction and a shorter dimension in a y-direction. Each field facet comprises a mirror that may be arranged to image the intermediate focus 6 onto the faceted pupil mirror device 11. To achieve this, the field facets may, for example, be concave.

The faceted pupil mirror device 11 comprises a plurality of pupil facets. The faceted pupil mirror device 11 is arranged to project an image of each field facet of the faceted field mirror device 10 onto an illumination region IR (also referred to as the slit or illumination slit) at the patterning device MA. The illumination system IL is configured so that each field facet is imaged on the illumination region IR in an overlapping manner. Desirably, in such known lithographic apparatus, each image of a field facet fills the illumination region IR. The overlap of the images of the field facets at least partially evens out irregularities in the radiation beam B provided by the radiation source SO.

The illumination region IR may be curved or straight. In general, in a scanning lithographic apparatus LA, the illumination region IR is elongate having a longer dimension and a shorter dimension. The shorter dimension may coincide with a scanning direction of the support structure MT and the longer dimension may coincide with a non-scanning direction. The illumination region IR may be curved or straight. The illumination region IR is indicated in Figure 1, which shows the patterning device in cross section. The longer dimension (in the x-direction) of the illumination region IR is perpendicular to the plane of Figure 1 and the shorter dimension (in the y-direction) of the illumination region IR lies in the plane of Figure 1.

It will be appreciated that the illumination region IR may have a shape in the plane of the patterning device MA that generally corresponds to that of each of the field facets, for example being generally of the form of the shape 28 shown in Figure 2b. Note that the shape and size of the projection of each field facet onto the plane of the patterning device MA may not be exactly the same as the illumination region IR and will depend on the magnification factors applied in the x and y directions by the field facet, the pupil facets (and any other optics in upstream of the illumination region IR). The edges of the illumination region IR may be defined by two sets of reticle masking blades (not shown), which may truncate the radiation such that radiation is not incident on the patterning device outside of the illumination region IR. Therefore, in such known lithographic apparatus, each of the field facets may be arranged such that in the absence of such reticle masking blades they would each overfill the illumination region IR. The illumination region IR may receive radiation from a central portion of each field facet, as indicated by the dotted line 29 inside the example shape 28 of a field facet shown in Figure 2b.

Therefore, in some existing EUV lithographic apparatus, a region surrounding the illumination region IR is also provided with EUV radiation (although the illumination region at the patterning device MA is masked from this portion of the EUV radiation, which is not used for exposing the substrate W). This region surrounding the illumination region IR may receive EUV radiation from an edge portion of each field facet mirror (which may be the portion disposed between the dotted line 29 and the edge of shape in the schematic illustration in Figure 2b). At least a part of this portion of the EUV radiation that is not used for exposing the substrate W may be incident on an energy sensor, which may be used to monitor and control a dose of radiation that is delivered to the substrate W.

It has been proposed to use a faceted field mirror device 10 and/or a faceted pupil mirror device 11 having a larger number of individually directable or movable reflective optical elements so as to provide better control over the illumination modes of the lithographic apparatus. For example, it has been proposed to use a faceted field mirror device 10 and/or a faceted pupil mirror device 11 comprising a micro-electromechanical system (MEMS) micro-mirror array.

In a typical lithographic system, a pattern on a reticle is illuminated and the resulting diffraction orders are collected and projected to form an aerial image at the wafer level. The aerial image may trigger a photochemical reaction in a photoresist layer on the wafer. Thus, a pattern may be transferred from the reticle to the wafer. An EUV lithography tool may use an EUV reflective reticle that may consist of a multilayer stack having EUV reflection portions and EUV absorption portions to define a pattern. A typical EUV mask in high volume manufacturing scenarios may, for example, use a tantalum (Ta) absorber. In some cases, for example when a pattern is highly regular and/or dense, an EUV mask may comprise an attenuated phase shift mask.

Typical EUV systems may optimize an illumination pupil (often referred to as a "pupil shape", "source") to increase printability and for high throughput for a given pattern on a reticle, however, typical EUV illuminators may not have flexibility to manipulate an angular distribution of the radiation exposing the reticle within an exposure field (i.e. different controllable pupils for different portions of the exposure field, each corresponding to different portions of the reticle). Thus, there may not be control over a pupil in an expose field. This lack of flexibility may be intrinsic to an optical design of the illumination system.

In general, a transmissive or reflective reticle comprises a large number of features. Each feature is imaged to the wafer subject to a large number of imaging conditions, among which the specific illumination shape (pupil) as received by said feature. In most lithographic tools the individual source points of the illumination source, e.g. corresponding to a specific angle of incidence on the reticle are mutually incoherent. The aerial image of said feature may then be constructed by summing across the illumination pupil all corresponding individual aerial images, each individual aerial image being associated with a particular angle of incidence of the illumination beam at the reticle.

A reflective reticle (e.g., an EUV reticle) may have an incident/diffraction angle dependent phase shift between diffraction orders. This may lead to misalignment of an aerial image at wafer level between different incidence angles. For a reticle based on absorption and reflection (e.g., a Ta reticle) this effect is known as "mask 3D effect". Where a pupil shape comprises a wide range of illumination angles, the aerial image will be effectively a sum of many individually shifted aerial images, each aerial image associated with a respective angle of the wide range of illumination angles. The resulting aerial image is then said to be subject to so-called M3D fading, which is basically a blurring of a mask image. M3D fading may also persist in attenuated phase shift masks. The main disadvantage of M3D fading is contrast loss. For example, an optimal pupil for a particular use case may be a y-dipole. An aerial image at wafer level may be a superposition of a north pole of the y-dipole and a south pole of the y-dipole. Experimentally, the aerial images from the north and the south pole may be aligned at wafer level to achieve optimal contrast. In practice, owing to mask 3D effects, the aerial images corresponding to the north and south poles may be misaligned (shifted with respect to each other) which may result in said blurring of the mask image (M3D fading) causing contrast loss.

The described effect of M3D fading is most pronounced for pupil shapes characterized by a large separation of individual poles. So for example dipoles, quadrupoles and hexapoles where the poles are situated close to or at the edge of the illuminator pupil.

Duo-monopole dual-exposures (as described in WO2020221556, incorporated herein by reference) may in some cases overcome the above-mentioned disadvantages. However, when implementing a duo monopole dual-exposures method, two exposures are required effectively halving throughput. By exposing one monopole, light in the complimentary monopole may be mostly lost, which may result in a throughput penalty. Two separate exposures may be used with a lower dose, one for the north pole and one for the south pole, but this may incur a penalty of additional overhead between exposures and low doses may lead to stage limited throughput.

In some cases, a fading compensation technique such as projection optics box (POB) fading injection (as described in WO2023104419A1, incorporated herein by reference) has been used to partially overcome the above-mentioned disadvantages of the dual-monopole exposure. POB fading injection may only provide a partial regain of contrast loss resulting from M3D effects. For example, POB fading injection may compensate for M3D effects by compensating for aerial misalignment by shifting aerial images of a north and south pole in a dipole region towards a nominal position. However, the POB fading injection described previously may only be operable on horizontal line space patterns.

With the lithographic apparatus LA according to the present disclosure, a pupil may be tuned across a scanning direction of an illumination region IR which may adjust the illumination mode across the scanning direction. This may be achieved by utilizing a pupil tuning ability of a suitable configurable illumination module such as, for example, a MEMS illuminator, to split the angular distribution of an exposure field (illumination region IR) in the scan direction (i.e., a y-direction) into, for example, a first angular distribution and a second angular distribution.

During exposures, the first angular distribution corresponding to a first portion of an illumination region IR and the second angular distribution corresponding to a second portion of an illumination region IR may overlap spatially in a transition region, or transition zone. The transition zone may correspond to a middle portion, or center portion, of the illumination region IR.

The first and second angular distributions may be complimentary angular distributions. That is, the first angular distribution may comprise a first peripheral region of a full angular distribution defined by a numerical aperture of the illuminator, and the second angular distribution may comprise a second peripheral region of the full angular distribution. Said first peripheral region and said second peripheral region may be located mirror symmetrically within said full angular distribution (typically referred to as the pupil plane of the illuminator optics). For example, the first and second angular distributions may comprise respective monopoles of opposite pole; e.g., the first angular distribution may comprise a monopole having a north pole and the second angular distribution may comprise a monopole having a south pole. In this way, the transition region may comprise a y-dipole comprised of an overlap of the first and second angular distributions, i.e., the complementary monopoles. Advantageously, this method may allow for a dual-monopole single exposure that may improve throughput. The y-dipole transition example may be beneficial when writing horizontal line space patterns.

The complimentary duo-monopole angular distribution with y-dipole transition described above is a non-limiting example. A complimentary duo-monopole angular distribution may have, for example, an x-dipole transition region, which may be beneficial for writing vertical line-space patterns. In some cases, the complimentary distribution may be a rotated duo-monopole, which may be beneficial for writing rotated line spaces. In some cases, the method may be extended to angular distributions corresponding to multipoles, for example quasar and hexapole angular distributions. In this case, the slit, or illumination region IR, may be split into a number of zones, i.e., at least two zones corresponding to different poles.

Advantageously, the transition zone, or transition region, where both the first and second angular distributions are present may be used for alignment purposes, for example reticle alignment.

In some example, POB linear fading (as described in WO2023104419A1) may be used to compensate for an offset between an aerial image of the first angular distribution and an aerial image of the second angular distribution at wafer level, e.g., compensating for displacement of the aerial image with a tilt of the reticle stage. This may improve contrast loss owing to reticle induced fading (M3D effects) and increase an overlapping process window (OPW). In some cases, the system drift (e.g., owing to thermal effects) causes projection lens aberration changes. The transition zone may be used to facilitate an aberration drift measurement and thus correction of said aberration.

In some embodiments, the illumination system IL of the lithographic apparatus comprises a first optical element and the angular distribution of the radiation at the illumination region IR is dependent on a spatial distribution of radiation received by the first optical element, but the first optical element is not disposed in the entrance pupil of the projection system PS or a plane conjugate thereto. The first optical element may be the faceted pupil mirror device 11 described above.

The angular distribution of the radiation at the illumination region IR is dependent on a spatial distribution of radiation received by the first optical element 11. However, the first optical element 11 is not disposed in the entrance pupil of the projection system PS or a plane conjugate thereto. This means that the projection of the entrance pupil of the projection system PS onto the first optical element 11 via each point of the illumination region IR maps, in general, onto a different portion of the first optical element 11. The inventors have realized that this can allow the first optical element 11 to be illuminated so as to create different illumination modes for different portions of the illumination region IR.

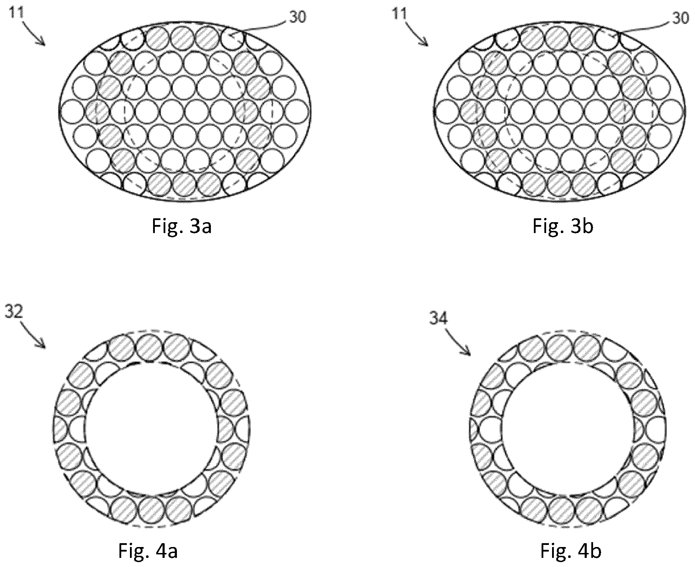

A simplified and schematic representation of the first optical element 11 is shown in Figures 3a and 3b. The first optical element 11 comprises a mirror array comprising an array of individually movable mirror facets (represented as circles). The mirror array 11 is arranged to receive radiation and to direct at least a portion of the received radiation to the illumination region IR. Some of the individual facets receive radiation (from a second optical element 10) and these are represented by hatched circles whereas some of the individual facets do not receive radiation and these are represented by empty circles. The angular distribution of the radiation at the illumination region IR is dependent on which of the array of individually movable mirror facets receives radiation. Also shown in Figures 3a and 3b is a projection 30 (an annulus represented by dashed lines) of the entrance pupil of the projection system PS onto the first optical element 11 for a first position in the illumination region IR (see Figure 3a) and a second position in the illumination region IR (see Figure 3b). For a given position in the illumination region IR, the pupil or illumination mode is the projection of the entrance pupil onto the first optical element 11. The illumination mode 32 (i.e. the overlap between the projection 30 and the first optical element 11) for the first position in the illumination region IR (as shown in Figure 3a) is shown in Figure 4a and the illumination mode 34 for the second position in the illumination region IR (as shown in Figure 3b) is shown in Figure 4b.

It will be appreciated that, since the first optical element 11 is not disposed in the entrance pupil of the projection system PS, or a plane conjugate thereto, the projection 30 of the entrance pupil of the projection system PS onto the mirror array 11 via each point of the illumination region IR maps, in general, onto a different portion of the mirror array (and therefore a different set of the individually movable mirror facets).

Because the first optical element 11 is not disposed in the entrance pupil of the projection system PS, or a plane conjugate thereto, as observed through the illumination region IR, the pupil will vary as across the illumination region IR. For example, as can be seen from Figures 3a and 3b, the "spots" of the illuminated individual mirror facets (i.e. the hatched circles) will appear to move or jump in the pupil plane as a function of position in the illumination region IR. Advantageously, this allows some control of the angular distribution received across the illumination region IR.

In some embodiments, each of the independently movable mirror facets of the first optical element 11 comprises a micro-electromechanical system (MEMS) micro-mirror. Therefore, for such embodiments, the first optical component 11 may be considered to comprise a MEMS micro-mirror array.

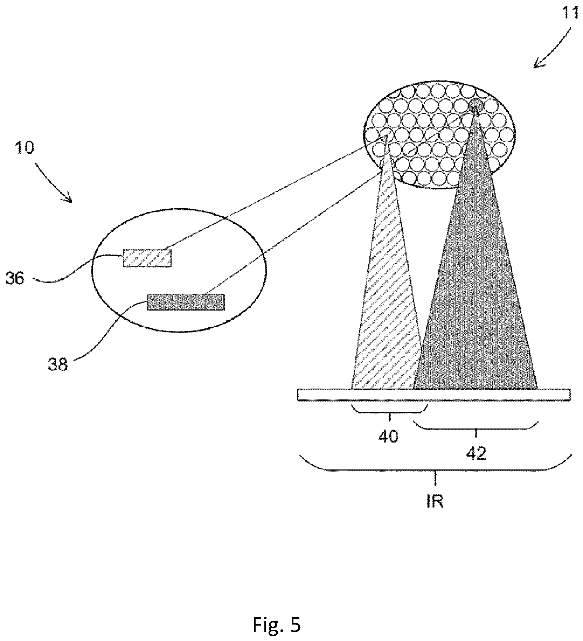

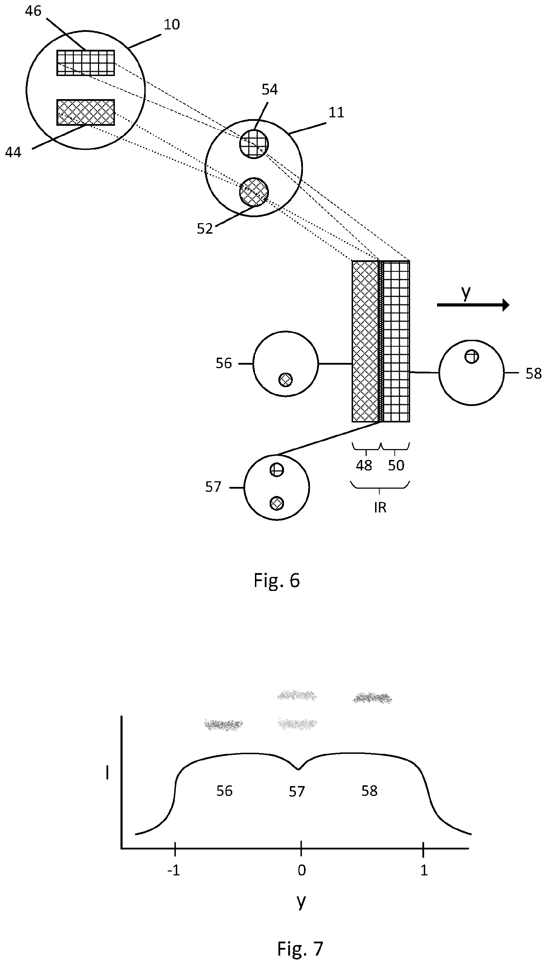

In some embodiments, the illumination region IR comprises a plurality of portions and the illumination system IL is configured to control the received radiation such that the portions of the received radiation directed to the different portions of the illumination region IR have a different angular distributions, as now discussed with reference to Figures 5 and 6. That is, different illumination modes may be used for different portions of the illumination region IR. For scanning lithographic apparatus (also known as scanners), the different portions of the illumination region IR may correspond to different positions in a scanning direction of the illumination region IR (which may be the y-direction).

As explained above, with reference to Figure 1, in some embodiments the illumination system IL further comprises a second optical element 10 that is arranged to receive radiation from a radiation source SO and to direct at least a portion of the received radiation to the first optical element 11. The second optical element may be the faceted field mirror device 10 described above.

The second optical element 10 may comprise a second mirror array comprising a two-dimensional array of individually movable mirror facets. In some embodiments, each of the independently movable mirror facets of the second optical element 10 comprises a micro-electromechanical system (MEMS) micro-mirror. Therefore, the second optical component 10 may be considered to comprise a MEMS micro-mirror array. The faceted field mirror device 10 may comprise of the order of 100,000 independently movable reflective optical elements. These reflective optical elements may substantially cover the portions 24, 26 of the faceted field mirror device 10 that receive radiation from the radiation source SO (see Figure 2a and accompanying discussion). In some embodiments, any gaps between adjacent reflective optical elements may be minimal.

In some embodiments, the two-dimensional array of independently movable reflective optical elements provided on the faceted field mirror device 10 may be considered to comprise a plurality of groups of reflective optical elements. Each group of reflective optical elements may comprise a plurality of adjacent independently movable reflective optical elements on the faceted field mirror device 10. Each of the plurality of groups of reflective optical elements may be referred to as a cluster of reflective optical elements.

The individually movable mirror facets of the two-dimensional array may be arranged differently from one another, as now discussed with reference to Figures 5 and 6.

As shown very schematically in Figure 5, in embodiments of the present disclosure the second optical element 10 may comprise different portions 36, 38 which may be of different sizes and/or shapes and which may be imaged onto different portions 40, 42 of the illumination region IR. This is in contrast to known arrangements wherein the second optical element 10 comprises a plurality of identical facets (or groups of MEMS mirrors which form identical virtual facets) which are all imaged onto the entire illumination region IR.

Each of the plurality of different portions 36, 38 may be considered to be a focusing element having optical power. Each of the plurality of focusing elements 36, 38 may, for example, be arranged to form an image of the intermediate focus 6 (i.e. a virtual radiation source) at or proximate to the first optical element 11 (i.e. the pupil facet mirror).

For example, in some embodiments, each of the focusing elements 36, 38 may comprise a concave mirror (for example one of the field facet mirrors described above in connection with Figure 1).

Alternatively, each of the plurality of focusing elements 36, 38 may comprise a group or cluster of the of individually movable mirror facets of the two-dimensional array. For example, each of the focusing elements may comprise a cluster of (generally flat) mirror facets (for example MEMS mirrors) that are arranged so as to collectively form a concave mirror.

Note that in order to ensure uniformity of the spatial distribution of radiation over the illumination region IR (which is important for dose control), each position in the illumination region IR may receive radiation from a plurality of focusing elements 36, 38 (although only two focusing elements are shown in Figure 5 for ease of understanding, it will be appreciated that in practice there may be of the order of 100 or 1000 focusing elements on the second optical element 10). However, in contrast to known arrangements, in embodiments of the present disclosure, in general, each position in the illumination region IR does not receive radiation from all of the focusing elements 36, 38.

Radiation directed by the two focusing elements 36, 38 shown in Figure 5 partially overlaps spatially at the illumination region IR. However, in contrast to known arrangements, in embodiments of the present disclosure, in general, the radiation directed by two different focusing elements does not substantially cover the illumination region IR and there may be an adjustable overlap between the radiation directed by two different focusing elements at the illumination region IR.

In some embodiments of the present disclosure, the second optical element may comprise a plurality of sets of focusing elements. Each set of focusing elements may be arranged to direct radiation to a different one of a plurality of portions of the illumination region IR. Radiation directed by two focusing elements from a given set may overlap spatially at the illumination region IR and may fill a corresponding portion of the illumination region IR. Radiation directed by two focusing elements from different sets may have an adjustable spatial overlap at the illumination region IR. An example of such an arrangement is now discussed with reference to Figure 6.

In the example shown in Figure 6, the second optical element 10 comprises two focusing elements 44 46. The first focusing element 44 is arranged to direct radiation to a first portion 48 of the illumination region IR. The second set of focusing element 46 is arranged to direct radiation to a second portion 50 of the illumination region IR. Radiation directed by the two focusing elements overlaps spatially at the illumination region IR and may fill a corresponding portion (either 48 or 50) of the illumination region IR.

It will be appreciated that although the focusing elements 44, 46 and the illumination region IR are shown as being generally rectangular in Figure 6, this is merely for ease of understanding the new arrangement of focusing elements 44, 46. In practice, the illumination region IR may match an entrance aperture of the projection system PS and may, for example, be of the form shown in Figure 2b and described above.

The first and second optical components 10, 11 are arranged so as to form an image of each of the focusing elements 44, 46 in a corresponding portion 48, 50 of the illumination region IR. All such images from a given set overlap spatially at the illumination region IR.

Each of the focusing elements may have substantially the same size and shape (which may be imaged onto the corresponding portion 48, 50 of the illumination region IR).

Each focusing element directs the radiation via different portions of the first optical element. For example, focusing element 44 directs radiation to the first portion 48 of the illumination region IR via portion 52 of the first optical element 11. Similarly, focusing element 46 directs radiation to the second portion 50 of the illumination region IR via portion 54 of the first optical element 11. In this way, the radiation beam is directed to the patterning device such that at least two different portions of the patterning device, differing at least in a position along a scanning direction of the illumination region, receive radiation from different regions of the illuminator optics (i.e., focusing element 44 and 46) within a pupil plane associated with the illuminator optics.

The pupils 56, 58, or illumination modes, for the two different portions 48, 50 of the illumination region IR are shown in Figure 7. In this example, the pupil 56 for the first portion 48 of the illumination region IR is a monopole comprising a south pole and the pupil 58 for the second portion 50 of the illumination region IR is a monopole comprising a north pole.

In the example shown in Figure 6, the illumination system IL (which comprises the first optical element 11 and the second optical element 10) is configured to control the radiation (received from a radiation source SO and directed to the patterning device MA) such that at a first portion 48 of the illumination region IR receives radiation having a first angular distribution 56 and a second portion 50 of the illumination region IR receives radiation having a second angular distribution 58, each angular distribution corresponding to a different region of the illuminator optics pupil plane. In particular, one end of the illumination region IR (for example in a scanning direction y) may receive radiation having the first angular distribution 56 and another end of the illumination region IR may receive radiation having the second angular distribution 58.

In the example shown in Figure 6, the first angular distribution 56 and the second angular distribution 58 may overlap in the illumination region IR corresponding to a center (i.e. the middle) of the slit in a third portion of the IR, transition region 57. In the example, because the first angular distribution 56 and the second angular distribution 58 comprise complementary monopoles (i.e., a north pole and a south pole), the transition region 57 may comprise a y-dipole.

The transition region 57 may be adjustable, for example by selecting (in case of actuable elements 44 and/or 46) particular sets of pupil facets 54 and 56. Advantageously, the transition region 57 may be tuned for a specific purpose. During monopole exposures, owing to an intrinsic non-telecentricity of the monopole (i.e., center of gravity of the angular distribution deviates significantly from the optical axis of the illuminator), stage alignment or projection lens related measurements may become sensitive to focus variation. A monopole may concentrate light on one side of a pupil, which may not be optimal for wavefront measurements that may require a uniformly filled pupil. In some cases, a diffuser (for example on a fiducial marker) has been used to homogenize a pupil to limited success. Thus, a monopole exposure may lead to high gradients in a pupil that may adversely affect wavefront measurements. Thus, the transition region may be provided with, for example, a dipole to facilitate stage alignment operations and wavefront measurements.

In an example, an alignment of an aerial image associated with a feature of a patterning device may depend on a coordinate of the radiation beam in a pupil plane associated with the illuminator optics. In some cases, for example owing to M3D effects, the aerial image may be misaligned at wafer level. That is, owing to fading effects, a north and south pole of a dipole illumination may be displaced on a wafer in a X direction. In accordance with aspects of the present disclosure, there may be provided a method of correcting said displacement by providing radiation having a first angular distribution and a second angular distribution to counteract said displacement. Said displacement may be associated with a difference between portions of the illumination regions. Said correction may be based on projection lens configuration or focus adjustment.

In some examples, said first and second angular distributions correspond to monopoles, wherein the full angular distribution is a y-dipole, and wherein a feature to be illuminated on the patterning device comprises vertical lines.

In some examples, said first and second angular distributions correspond to monopoles, wherein the full angular distribution is an x-dipole, and wherein a feature to be illuminated on the patterning device comprises horizontal lines.

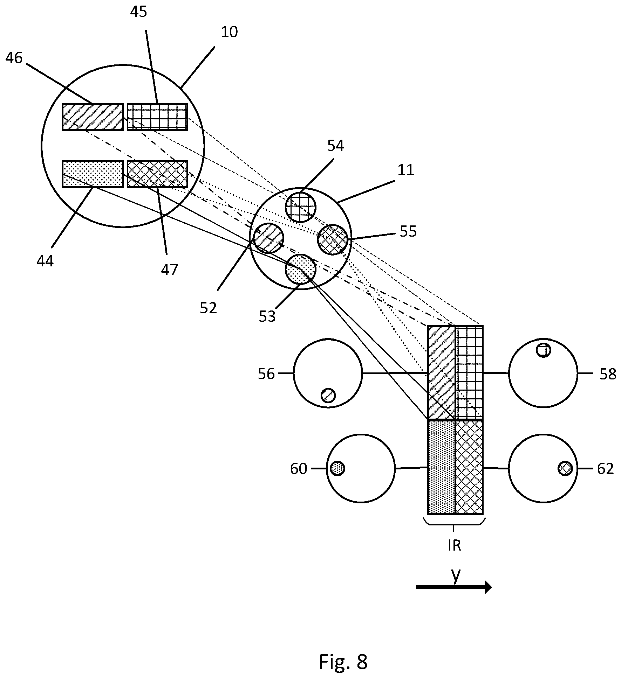

In the example shown in Figure 8, the first optical component 11 comprises four focusing element 44 45 46 47 are arranged to direct radiation to the illumination region IR via portion 52 53 54 55 of the first optical element 11 to form an image of each of the focusing elements 44 45 46 47 in a corresponding portions of the illumination region IR. In this example, angular distributions 56 58 60 62 vary in a scanning (i.e., Y) and a non-scanning (i.e., X) direction. In other examples not illustrated, the illumination region IR may be illuminated with radiation having any number of varying angular distributions in corresponding portions of the illumination region IR in a scanning or a non-scanning direction as required by any particular use case.

In some cases, an imaging improvement process (e.g., overlay optimization) may be realized where an interaction between pupil non-telecentricity through scan and a focus error may lead to an overlay error on a wafer. For example, a monopole illumination, which may be intrinsically non-telecentric, may be co-optimized with focus control, i.e., a focus variation through scan, to impose a pattern shift that may counteract an existing overlay error, or to anticipate a predicted overlay error. In contrast to the aforementioned contrast enhancement operations, overlay improvement operations may prefer a telecentric illumination through scan. Thus, the illumination region IR may be tuned in order to balance between contrast gain and minimize overlay error. That is, the illumination region IR or control thereof becomes a control knob for correcting overlay. The entire illumination region IR may be tuneable to facilitate any particular use case. For example, when stitching two fields it may be beneficial to tune a pupil at the peripheries of illumination regions that are to be stitched.

In some cases, for example depending on a pattern to be written, it may be beneficial to provide an asymmetric angular distribution (i.e., in the illumination region IR in the scanning direction). For example, M3D induced intensity effects may be minimized by having an asymmetric exposure condition, e.g., the pupil shape changes along the scan direction across the illumination area. For a specific type of feature (e.g., horizontal or vertical line spacing). In this case, an intensity of the first angular distribution may be different from an intensity of one or more second angular distributions to account for M3D induced intensity effects. That is, there may be some periods during a scan when one end of the illumination region IR illuminates (e.g., with a monopole) independently of another end of the illumination region IR in at least a scanning direction.

Owing to the reflective nature of an EUV mask, the mask is illuminated with EUV radiation at a chief ray angle at object (CRAO) of 6 degrees. The chief ray azimuthal angle of the EUV radiation may follow a curvature of an illumination slit, or illumination region IR, which may cause the angle of radiation at the extremities of the illumination region IR to vary by +/- 6 degrees which in turn may result in a pattern shift at wafer level. Furthermore, an EUV mask may have an angular dependent reflectivity. That is, a varying incident angle of radiation on said mask may result in a different reflectivity, which may result in M3D effects causing a further pattern shift. The varying degree of radiation angle owing to the curvature of the illumination region IR in addition to the reflective asymmetry of an EUV mask may be a cause of non-telecentricity (i.e., a center of gravity of the angular distribution may deviate from the optical axis of the illuminator). For example, at one end of the illumination region IR there may be a negative shift in telecentricity, and at an opposite end of the illumination region IR there may be a positive shift in telecentricity which may result in a pattern shift and loss of contrast. In order to counteract said non-telecentricity, there may be provided a method comprising determining, based on a chief ray angle at object and a chief ray azimuthal angle, a pattern shift or predicted pattern shift on a wafer, and determining an angular distribution of radiation in an illumination region IR based on the pattern shift or predicted pattern shift, wherein the angular distribution in the illumination region IR varies in at least a scanning direction of an illumination region IR. In a purely exemplary angular distribution, an illumination region IR may comprise first and second monopoles distributed in a scanning direction of an illumination region IR, wherein the first monopole may comprise a first illumination intensity and the second monopole may comprise a second illumination intensity different from the first illumination intensity. The first and second illumination intensities may be determined based on the chief ray angle at object and chief ray azimuthal angle of radiation.

Figure 7 shows a plot of illumination intensity (I) vs. illumination region IR length in a scanning direction (y) for the exemplary complimentary dual-monopole exposure. Complimentary monopole regions 56 and 58 can be observed, along with dipole transition region 57. The transition region 57 may be adjusted for different applications.

In some cases, it may not be possible to optimize an exposure for all operations, e.g., reticle alignment, wavefront correction, imaging improvement and overlay improvement. For example, overlay improvement may require a variation of the telecentricity through a scan, but contrast improvement requires non-telecentricity (i.e., a split of poles) through a scan. In this case, an exposure (i.e., angular distribution through the illumination region IR) may be co-optimized to provide a best-case scenario. Such a co-optimization may co-optimize for, for example, an imaging metric or placement metric (e.g., overlay or edge placement error) and contrast. Some optimization processes are described below and may be based on, for example, focus control over a wafer, the type of layer being printed and/or an edge placement error (EPE) formula. Said optimization processes may also be applied, for example, to optimize POB fading injection. Another co-optimization process which may be suitable or adapted for this application is described in US2022/0334499A1 which is incorporated herein by reference.

It is known that scanners may comprise components that may degrade across a lifetime of said component or scanner. In such cases of said component degradation, it may be difficult to consistently repeat identical exposures and thus illuminations in order to repeat specific patterns on a wafer. That is, an expected pupil may change over time which may be a cause of variations in a system fingerprint. In other cases, the use of legacy tools (i.e., legacy scanners) in conjunction with state-of-the-art scanners in multi-tool exposure processes may lead to a mismatch of exposures or illuminations (also known as tool-to-tool matching), for example owing to component degradation over time (e.g., in a collector or an illuminator), or differences in manufacturing and/or setup tolerances. This may result in a pupil mismatch between tools that may, for example, adversely affect overlay performance, either across the lifetime of a tool or between tools, and thus critical dimension performance. To alleviate these issues, there may be provided a method of matching a first angular distribution to a second angular distribution. A first angular distribution (e.g., as provided by a first tool), may be determined and used as a baseline angular distribution. A second angular distribution (e.g., from a second tool, or from the first tool at a different point in time) may be determined and optimized based on the first angular distribution. This is realized by modifying the second angular distribution (e.g., by using the presently described illumination system IL comprising first and second optical elements, 11, 10) in an illumination region IR in at least a non-scanning direction in order to minimize the differences between the first angular distribution and the second angular distribution. The second angular distribution may be realized by optimizing the angular distribution based on selected critical dimension features on a target. Thus, pupil variation (e.g., as a result of component degradation or tool-to-tool matching) may be minimized.

In some cases, M3D effects may result in a non-uniform exposure of a field (i.e., an exposure field of a wafer) towards an edge, or rim of a wafer, which may result in a diagonal CD fingerprint variation with respect to a scanning (i.e., Y) and non-scanning (i.e., X) direction. In accordance with aspects of the present disclosure, there may be provided a method of providing a uniform exposure comprising determining a non-uniformity or predicted non-uniformity of an exposure and determining an angular distribution of radiation in an illumination region IR based on the non-uniformity or predicted non-uniformity, said angular distribution varying in at least a scanning direction. In some cases, the angular distribution may be fixed, or constant, in a non-scanning direction (i.e., X) and the angular distribution may differ, or be dynamically varied in a scanning direction (i.e., Y) based on said determined non-uniformity or predicted non-uniformity. In this way, for example, a diagonal CD fingerprint variation may be minimized.

In some cases, such as described in WO2023104419A1, a known method of overlay correction (i.e., POB fading) may comprise, for example, tilting a reticle and/or a wafer stage or configuring a projection lens to modify the angular distribution of radiation comprised in an illumination region IR. In a specific example, processes that involve wafer bonding may result in wafer deformations that may lead to overlay errors. A known correction method may comprise configuring a projection lens to modify the angular distribution of radiation comprised in an illumination region IR as represented by one or more Zernike functions (for example Z2, also known as a Z2 injection, which may correspond to an image displacement in an x-direction). In some cases, POB fading injection may lead to further fading errors. For example, a Z2 injection may lead to a Z3 fading error which may correspond to a y-displacement of imaged features resulting in contrast loss. Such fading may impact CD and contrast performance of horizontal and 2D features.

In accordance with aspects of the present disclosure, there may be provided a method of mitigating overlay correction induced errors by providing radiation having an angular distribution (e.g., by using the presently described illumination system IL comprising first and second optical elements, 11, 10) that may correspond to a telecentric offset in an illumination region IR in at least a scanning direction. The angular distribution may be determined based on an error introduced by said overlay correction. In some examples the error may be an image offset. In the example above wherein a Z3 fading error is introduced by an overlay correction, an angular distribution may be determined based on a y-displacement of image features or a predicted y-displacement of image features, wherein the angular distribution may correspond to a telecentric y-offset in the illumination region IR. In some cases, the method may further comprise tilting a wafer stage to provide a linear focus profile through a scan. That is, providing radiation having an angular distribution that may correspond to a telecentric offset in an illumination region IR may result in further fading errors in a z-direction. Accordingly, a telecentric offset may be determined to optimally counteract overlay correction induced errors, and a wafer stage tilt may be determined accordingly to provide an optimal focus through scan. Alternatively, a wafer stage tilt may be determined to provide an optimal focus through scan based on focus sensitive features on a wafer, and subsequently a telecentric offset may be determined based on an overlay correction induced error. In some examples an amount of wafer stage tilt (i.e., focus) and telecentric offset are optimized to find a balance between best overlay performance and best focus performance.

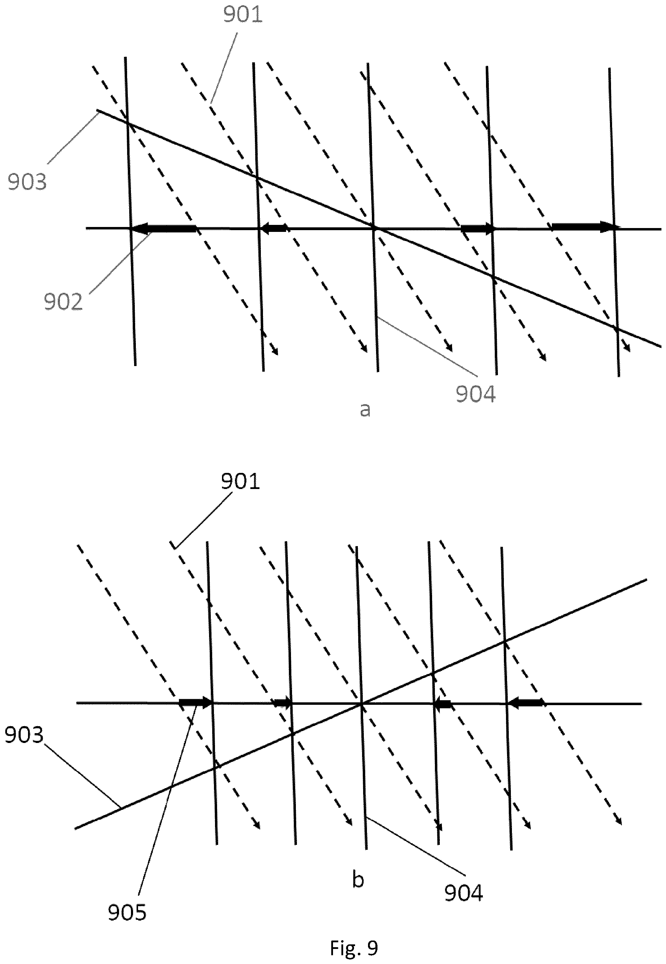

Figure 9a shows an example describing how non-telecentric illumination 901 (non-telecentric with respect to optical axis 915) combined with a focus offset 903 (e.g., owing to projection lens modification) with respect to a focus plane 904 may induce a field position dependent pattern shift 902. By configuring the non-telecentricity and focus offset across the exposure field the pattern shift may for example be configured to counteract an existing overlay error. Figure 9b shows an example of how a reduced overlay error 905 may be achieved by a combination of non-telecentric illumination 901 as provided by pupil variation (i.e., an angular distribution corresponding to a telecentric offset) and a focus offset variation 903 as provided by wafer stage tilt in accordance with aspects of the present disclosure. That is, a reduced overlay error (i.e., the solid black arrows 905 shown in Figure 9b) may be provided with respect to an existing overlay error (not shown) by leveraging the combination of non-telecentric illumination 901 and a properly chosen focus offset / tilt 903.

### Correction of edge roll off

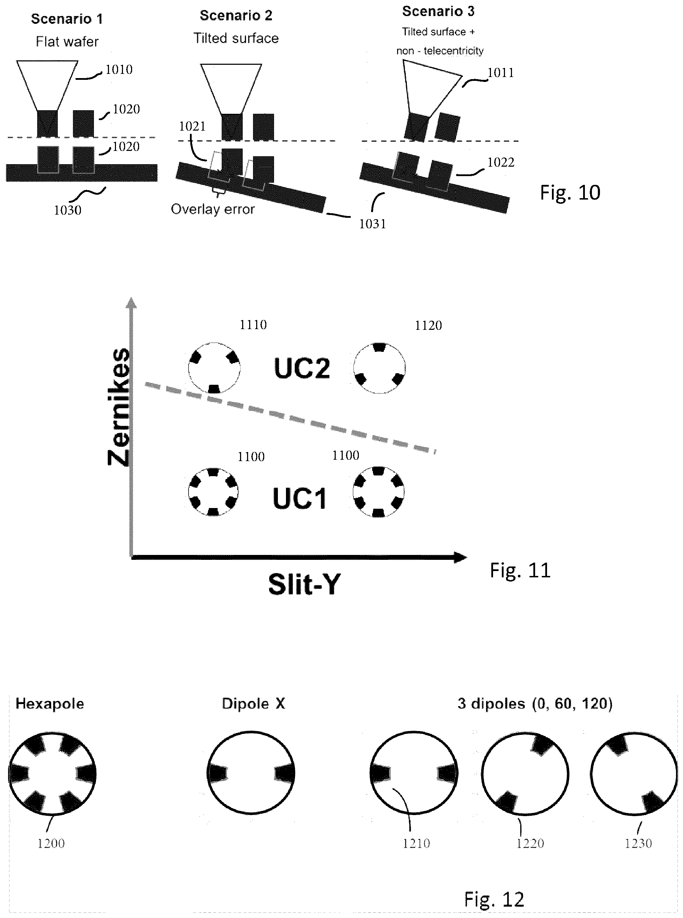

In another example it is an objective of the invention to configure the illumination 901 in order to mitigate substrate un-flatness related pattern placement errors (PPE) causing overlay errors. The substrate (wafer) un-flatness may be for example a so-called Edge Roll-Off (ERO) caused by the fact that the wafer is not flat and less effectively clamped to the substrate table at the edge region. This leads to a locally tilted wafer surface at the edge region of the wafer. In case of telecentric illumination of the wafer edge region (e.g. targeted to pattern a flat wafer) the local tilt causes a local PPE (overlay error) as the wafer surface does not coincide with the assumed flat wafer plane perpendicular to the optical axis of the optics. To counteract the ERO induced PPE the illumination 901 may be configured to have a variation in non-telecentricity counteracting the ERO related overlay error variation across the edge region. It is proposed to implement the overlay correction by imposing a pupil variation across one or more portions of one or more illumination regions within the edge region of the wafer. In an embodiment the pupil variation may induce a non-telecentric condition which anticipates an image offset (variation) in a XY plane of the wafer (associated with a PPE) due to a local wafer tilt (variation). The principle behind the overlay error correction is depicted in figure 10. In a first scenario (scenario 1) a flat region of wafer 1030 is patterned by imaging a pattern 1020 using a tele-centric illumination mode 1010. In scenario 2 the same tele-centric illumination mode is used to pattern a (locally) tilted wafer region 1031. Due to the tilted surface the pattern 1020 will not coincide with an intended pattern placement 1021 (depicted by grey boxes), hence introducing a pattern shift causing an overlay error. Scenario 3 depicts the situation wherein a deliberate amount of non-telecentricity is introduced by patterning the tilted wafer region 1031 using a non-telecentric illumination mode 1011. The pattern 1022 is now again coinciding with its intended pattern placement 1021, hence at least reducing the pattern placement error and consequently potential overlay errors.

As a rule of thumb the required non-telecentricity equals the overlay error divided by the focus variation giving rise to the overlay error. The overlay error due to a tilted wafer surface 1031 can be calculated by multiplying the wafer surface tilt with half of the wafer thickness.

### Reducing fading by pupil shape variation

As explained in previous sections of this document the so-called Mask 3D effect may induce scan position dependent image shifts (fading) manifesting itself as image contrast lost. In addition to mask 3D effects also projection optics aberration variation across the scanning direction may induce said fading and hence affect image contrast. It has been found that by configuring the illumination pupil across different portions of the illumination region along the scanning direction at least part of the aberration induced fading can be counteracted. Figure 11 depicts an example where a hexapole illumination pupil 1100 was split into a first tri-pole 1110 associated with a first portion of the illumination region and a second tri-pole 1120 associated with a second portion of the illumination region, wherein the first and the second illumination region are separated in the scan direction "Slit-Y". It was found that the double tri-pole configuration (Use Case 2; "UC2" in figure 11) reduced, compared to the hexapole pupil (Use Case 1; "UC1" in figure 11), aberration induced contrast loss from 9% to 2% if the aberration level was a 1nm/mm tilt of a comatic aberration (Zernike 5 and/or 6), as depicted by the dashed line in figure 11 representing the Zernike coefficient as a function of the Slit-Y coordinate (e.g. along scanning direction).

### Inducing fading by aberration control

In some cases the mask 3D effect caused fading may be at least partially corrected by inducing a counteracting projection optics aberration variation along the scanning direction. This may be further improved by also selecting an appropriate variation of the illumination pupil across different portions of the illumination regions along said scanning direction. For example it was found that the previously discussed hexapole illumination configuration may be split into three dipole pupils (each having a different orientation) for each corresponding portion of the illumination region, while further injecting a linear variation of a Z5 aberration across said portions of the illumination region along the scanning direction. Figure 12 depicts the decomposition of hexapole 1200 into three dipoles, each dipole associated with a different illumination region oriented along the scanning direction "Slit-Y". The dipole configuration each dipole is a dipole-X 1210, 60 degree rotated dipole-X 1220 or a 120 degree rotated dipole-X 1230.

### Improving z-profile resist by dynamic pupil shape control

So far the objective of the illumination pupil variation along the scanning direction has been to counteract or induce an aerial image shift variation within a plane of the substrate (e.g. associated with PPE / overlay errors). However the described methods of pupil shape control may also be utilized to control the focal position of the aerial image during the scanning direction in order to homogenize the aerial image through the resist stack. In an embodiment various portions of an illumination region have different illumination pupils (for example different mono-poles comprised within a dipole or quadrupole shape) such that each portion (each portion separated in the scanning direction) is associated with a different focal position of the aerial image. Optionally the projections optics may be configured to further inject a focus (Z4) tilt along the scanning direction to further homogenize the aerial image along the resist stack.

### Double exposure based fading reduction using different regions on the mask or different masks

In another embodiment it may be decided to not apply a position dependent illumination pupil during scanning operation, but to perform a double exposure type scanning operation with two different pupil shapes and a position shift between the scanning exposures to account for the pupil shape dependent image shift (causing the fading). This method may achieve similar reduction of mask 3D effect caused fading when selecting a suitable set of pupil shapes and a well-chosen position shift. Disadvantage of this method is that the chosen position shift may only be adequate for a narrow range of features on the mask, for example features with a small pitch may need a larger position shift than features with a small pitch, or vice versa. It is proposed to overcome this disadvantage by using either of below mentioned methods:
1) split the scanning exposures in two exposures as explained above, but use a different mask ("reticle") for each exposure. Each mask is configured to be illuminated with its corresponding pupil shape and in addition is configured to apply different position shifts for different features (different pitches for example) such that each feature receives an optimal position shift between the different exposures.
2) split the scanning exposures in two exposures as explained above, but instead of different masks use a different region of the mask ("reticle") for each exposure, each region being configured to be illuminated with its corresponding pupil shape and in addition configured to apply different position shifts for different features (different pitches for example) such that each feature receives an optimal position shift between the different exposures.

It has been found that when using the proposed methods for applying feature specific position shifts between exposures a 17% better Image Log Slope (ILS) can be obtained compared to a dual monopole exposure based on a single mask / single mask region configuration. The features in this case where L/S gratings across a pitch range of 28-150nm.

In an embodiment a method of configuring a lithographic apparatus comprising illuminator optics for directing at least a portion of a radiation beam to an illumination region of a patterning device so as to impart a pattern to the radiation beam and form a patterned radiation beam is provided, the method comprising: configuring the illuminator optics such that at least two different portions of the patterning device, differing at least in position along a scanning direction of said illumination region, receive radiation from different regions within a pupil plane associated with the illuminator optics, wherein each of the different portions comprises a plurality of features which are positioned such that corresponding positions on a substrate of each feature out of the plurality of features are nominally equal between said different portions when the different portions are provided to the same region on said substrate by said lithographic apparatus when used in a double-exposure setting.

In an embodiment the plurality of features are lines and spaces (L/S) having different pitches.

In an embodiment the different regions within the pupil plane are associated with different poles of a dipole pupil shape.

Further embodiments of the invention are disclosed in the list of numbered clauses below:
1. A method of configuring a lithographic apparatus comprising illuminator optics for directing at least a portion of a radiation beam to an illumination region of a patterning device so as to impart a pattern to the radiation beam and form a patterned radiation beam, the method comprising: configuring the illuminator optics such that at least two different portions of the patterning device, differing at least in position along a scanning direction of said illumination region, receive radiation from different regions within a pupil plane associated with the illuminator optics.
2. The method of clause 1 further comprising: receiving, at a first portion of the illumination region, radiation having a first angular distribution and receiving, at a second portion of the illumination region radiation having a second angular distribution; wherein the first portion and the second portion are separated in a scanning direction.
3. The method of clause 2, further comprising receiving radiation such that the first angular distribution and the second angular distribution overlap at a third portion of the illumination region.
4. The method of clause 3, where an angular distribution and area at the third portion is adjustable based on adjustment of the first angular distribution and/or the second angular distribution.
5. The method of any of clauses 3 or 4, further comprising using the third portion of the illumination region for measurement of at least one of: reticle alignment, optical aberration related to projection optics used in imaging the patterning device to a target portion of a substrate, or for imaging improvement.
6. The method of any of clauses 2 to 5, wherein an alignment of an aerial image associated with a feature on the patterning device depends on a coordinate of the radiation beam in said pupil plane and the method further comprises correcting an aerial image displacement associated with a difference between the portions of the illumination regions.
7. The method of clause 6, wherein the correcting is based on at least one of focus adjustment or projection lens configuration.
8. The method of clause 6 or clause 7, wherein the aerial alignment displacement is caused by mask 3D effects.
9. The method of any of clauses 2 to 8, wherein said first angular distribution relates to a first peripheral region of a full angular distribution defined by a numerical aperture capturing said portion of the radiation beam, and said second angular distribution relates to a second peripheral region of the full angular distribution, said first peripheral region and said second peripheral region being located mirror symmetrically within said full angular distribution.
10. The method of any preceding clause further comprising, optimizing the different angular distributions based on a compromise of at least two of: reticle alignment, optical aberration measurement and correction, or imaging improvement.
11. The method of any preceding clause comprising optimizing the different angular distributions and their area in a split through scan based on a compromise of at least a placement metric and a contrast metric.
12. The method of any of clauses 10 or 11, wherein the optimization is performed using at least one of source mask optimization, optical proximity correction, or cost function reduction.
13. The method of any preceding clause wherein said illumination region comprises the only region of the patterning device illuminated by said at least a portion of the radiation beam at any instance of time.
14. The method of any preceding clause, wherein said first and second angular distributions correspond to monopoles, wherein the full angular distribution is a y-dipole, and wherein a feature to be illuminated on the patterning device comprises vertical lines.
15. The method of any of clauses 1 to 13, wherein said first and second angular distributions correspond to monopoles, wherein the full angular distribution is an x-dipole, and wherein a feature to be illuminated on the patterning device comprises horizontal lines.
16. The method of any of clauses 1 to 15, further comprising: receiving radiation at a plurality of portions of the illumination region, each portion corresponding to an angular distribution of radiation different from the other portions, wherein the plurality of portions are separated in a scanning and a non-scanning direction.
17. The method of any of clauses 1 to 15, further comprising: determining a first full angular distribution of radiation at the patterning device; determining a second full angular distribution of radiation at the patterning device; and modifying the second angular distribution based on the first full angular distribution in order to minimize the differences between the first angular distribution and the second angular distribution wherein the second full angular distribution differs at least in position along a scanning direction of said illumination region.
18. The method of any of clauses 1 to 15, further comprising: determining an incident angle of radiation corresponding to at least a portion of the illumination region; projecting the patterned radiation beam onto a target region of a substrate; determining or predicting a pattern shift at a substrate level based on said incident angle of radiation; and determining an angular distribution of radiation in the illumination region based on said determined or predicted pattern shift, wherein the angular distribution differs at least in position along a scanning direction of said illumination region.
19. The method of clause 18, wherein the angular distribution of radiation in the illumination region comprises a first monopole and a second monopole, wherein the first monopole comprises a first illumination intensity and wherein the second monopole comprises a second illumination intensity different from the first illumination intensity.
20. The method of any of clauses 1 to 15, further comprising: projecting the patterned radiation beam onto a target region of a substrate; determining or predicting a non-uniformity of an exposure at a substrate level; and determining an angular distribution of radiation in the illumination region based on said determined or predicted non-uniformity, wherein the angular distribution differs at least in position along a scanning direction of said illumination region.
21. The method of clause 20, wherein the angular distribution is constant in a non-scanning direction of the illumination region, and wherein the angular distribution differs in a scanning direction based on said determined or predicted non-uniformity.
22. The method of any of clauses 1 to 15, further comprising: projecting the patterned radiation beam onto a target region of a substrate; determining or predicting an image offset at a substrate level; and determining an angular distribution of radiation in the illumination region based on the determined or predicted image offset, wherein the angular distribution corresponds to a telecentric offset in the illumination region.
23. The method of clause 22, further comprising: determining an optimal focus through scan at substrate level; and performing a substrate stage tilt to provide said optimal focus through scan.
24. The method of clause 23, further comprising optimizing said angular distribution and optimal focus through scan based on a compromise of at least overlay performance and focus performance.
25. A method of illuminating a feature on a patterning device comprising: generating a radiation beam; directing, using illuminator optics, at least a portion of the radiation beam to an illumination region of the patterning device so as to impart a pattern to the radiation beam and form a patterned radiation beam; and projecting the patterned radiation beam onto the target region of a substrate; wherein an angular distribution of the patterned radiation beam is provided with spatial and/or temporal separation in at least a non-scanning direction.
26. An illumination system for a lithographic apparatus, being operable to: receive radiation and to direct at least a portion of the received radiation to an illumination region of a patterning device so as to impart a pattern to the radiation and form a patterned radiation beam; and project the patterned radiation beam onto a target region of a substrate; wherein the illumination system is operable to direct the radiation beam to the patterning device such that at least two different portions of the patterning device receive, in a scanning direction of said illumination region, radiation having different angular distributions.
27. The illumination system of clause 26 wherein the illumination system is operable to control the received radiation such that at a first portion of the illumination region receives radiation having a first angular distribution and a second portion of the illumination region receives radiation having a second angular distribution; wherein the first portion and the second portion are separated in a scanning direction.
28. The illumination system of clause 27, wherein the illumination system is further operable to control the received radiation such that the first angular distribution and the second angular distribution overlap at a third portion of the illumination region.
29. The illumination system of clause 28, wherein the illumination system is further operable to adjust the area and angular distribution of radiation at the third portion based on the first angular distribution and the second angular distribution.
30. The illumination system of clauses 26 to 29 wherein said first angular distribution relates to a first peripheral region of a full angular distribution defined by a numerical aperture capturing said portion of the radiation beam, and said second angular distribution relates to a second peripheral region of the full angular distribution, said first peripheral region and said second peripheral region being located mirror symmetrically within said full angular distribution.
31. The illumination system of any of clauses 27 to 30 wherein the illumination system comprises a projection system operable to correct an aerial image displacement of an aerial image associated with a feature on the patterning device, said displacement associated with a difference between portions of the illumination regions.
32. The illumination system of clause 31, wherein the illumination system is operable to correct the aerial displacement based on at least one of focus adjustment or projection lens configuration.
33. The illumination system of any of clauses 29 to 32, wherein the illumination system is further operable to use the third portion of the illumination region for at least one of: reticle alignment, optical aberration measurement and correction, or imaging improvement.
34. The illumination system of any of clauses 26 to 33, wherein the illumination system is further operable to optimize the different angular distributions based on a compromise of at least two of: reticle alignment, optical aberration measurement and correction, or imaging improvement.
35. The illumination system of clause 34, wherein the illumination system is further operable to perform optimization using at least one of source mask optimization, optical proximity correction, or cost function reduction.
36. The illumination system of any of clauses 26 to 35 wherein the illumination system comprises:
   a first optical element; and wherein the different angular distributions of the radiation at the illumination region are dependent on a spatial distribution of radiation received by the first optical element.
37. The illumination system of clause 36, wherein the first optical element comprises a mirror array comprising an array of individually movable mirror facets, the mirror array arranged to receive radiation and to direct at least a portion of the received radiation to the illumination region; and wherein the different angular distributions of the radiation at the illumination region are dependent on which of the array of individually movable mirror facets receives radiation.
38. The illumination system of any one of clauses 36 or 37 wherein the illumination system further comprises: a second optical element that is arranged to receive radiation from a radiation source and to direct at least a portion of the received radiation to the first optical element; wherein the second optical element comprises a second mirror array comprising a two-dimensional array of individually movable mirror facets.
39. The illumination system of clause 38 wherein each of the independently movable mirror facets of the first or/and second optical element comprises a micro-electromechanical system micro-mirror.
40. The illumination system of any one of clauses 38 or 39 wherein the second optical element comprises a plurality of focusing elements having optical power.
41. The illumination system of clause 40 wherein each of the plurality of focusing elements comprises a group or cluster of the of individually movable mirror facets of the two-dimensional array.
42. The illumination system of clause 40, wherein the second optical element comprises a plurality of sets of focusing elements, wherein each set of focusing elements is arranged to direct radiation to a different one of said at least two different portions of the illumination region.
43. The illumination system of any of clauses 26 to 42, operable to direct the radiation beam such that said first and second angular distributions are monopoles, wherein the full angular distribution is a y-dipole, and wherein a feature to be illuminated on the patterning device comprises vertical lines.
44. The illumination system of any of clauses 26 to 42, operable to direct the radiation beam such that said first and second angular distributions are monopoles, wherein the full angular distribution is an x-dipole, and wherein a feature to be illuminated on the patterning device comprises horizontal lines.
45. The illumination system of any of clauses 26 to 44, operable to: direct radiation to a plurality of portions of the illumination region, each portion corresponding to an angular distribution of radiation different from the other portions, wherein the plurality of portions are separated in a scanning and a non-scanning direction.
46. The illumination system of any of clauses 26 to 44, operable to: determine a first full angular distribution of radiation at the patterning device; determine a second full angular distribution of radiation at the patterning device; and modify the second angular distribution based on the first full angular distribution in order to minimize the differences between the first angular distribution and the second angular distribution wherein the second full angular distribution is modified at least in position along a scanning direction of said illumination region.
47. The illumination system of any of clauses 26 to 46, operable to: determine an incident angle of radiation corresponding to at least a portion of the illumination region; determine or predict a pattern shift at a substrate level based on said incident angle of radiation; and control the received radiation to provide an angular distribution of radiation in the illumination region based on said determined or predicted pattern shift, wherein the angular distribution differs at least in position along a scanning direction of said illumination region.
48. The illumination system of clause 47, operable to control the received radiation such that the angular distribution of radiation in the illumination region comprises a first monopole and a second monopole, wherein the first monopole comprises a first illumination intensity and wherein the second monopole comprises a second illumination intensity different from the first illumination intensity.
49. The illumination system of any of clauses 26 to 46, operable to: determine or predict a non-uniformity of an exposure at a substrate level; and control the received radiation to provide an angular distribution of radiation in the illumination region based on said determined or predicted non-uniformity, wherein the angular distribution differs at least in position along a scanning direction of said illumination region.
50. The illumination system of clause 49, wherein the angular distribution is constant in a non-scanning direction of the illumination region, and wherein the angular distribution differs in a scanning direction based on said determined or predicted non-uniformity.
51. The illumination system of clauses 26 to 46, operable to: determine or predict an image offset at a substrate level; and control the received radiation to provide an angular distribution of radiation in the illumination region based on the determined or predicted image offset, wherein the angular distribution corresponds to a telecentric offset in the illumination region.
52. A lithographic apparatus comprising the illumination system according to any of clauses 26 to 51.
53. The lithographic apparatus of clause 52 comprising a substrate stage, the lithographic apparatus operable to: determine an optimal focus through scan at a substrate level; perform a substrate stage tilt to provide said optimal focus through scan, and optimize the angular distribution and optimal focus through scan based on a compromise of at least overlay performance and focus performance.
54. A method of forming a pattern on a target region of a substrate, the method comprising:
   generating a radiation beam; directing, using illuminator optics, at least a portion of the radiation beam to an illumination region of a patterning device so as to impart a pattern to the radiation beam and form a patterned radiation beam; and projecting the patterned radiation beam onto the target region of the substrate; wherein the radiation beam is directed to the patterning device such that at least two different portions of the patterning device, differing at least in position along a scanning direction of said illumination region, receive radiation from different regions of the illuminator optics within a pupil plane associated with the illuminator optics.
55. The method of clause 22, wherein the predicted image offset is associated with a local tilt of the substrate.
56. The method of clause 6 or clause 7, wherein the aerial alignment displacement is caused by an aberration variation along the scanning direction.
57. The method of clause 8, further comprising inducing an aberration variation along the scanning direction in dependence of the aerial image displacement and the configuring of the illuminator optics.
58. The method of clause 2, wherein a focal position of an aerial image associated with a feature on the patterning device depends on a coordinate of the radiation beam in said pupil plane and the method further comprises homogenizing the aerial image based on a difference in focal positions between the portions of the illumination region.
59. The method of clause 1, wherein each of the different portions comprises a plurality of features which are positioned such that corresponding positions on a substrate of each feature out of the plurality of features are nominally equal between said different portions when the different portions are provided to the same region on said substrate by said lithographic apparatus when used in a double-exposure setting.
60. A computer program comprising program instructions operable to perform the method of any of clauses 1 to 25 or 54 to 59, when run on a suitable apparatus.
61. A non-transient computer program carrier comprising the computer program of clause 60.

It is often desirable to be able to computationally determine how a patterning process would produce a desired pattern on a substrate. Computational determination may comprise simulation and/or modeling, for example. Models and/or simulations may be provided for one or more parts of the manufacturing process. For example, it is desirable to be able to simulate the lithography process of transferring the patterning device pattern onto a resist layer of a substrate as well as the yielded pattern in that resist layer after development of the resist, simulate metrology operations such as the determination of overlay, and/or perform other simulations. The objective of a simulation may be to accurately predict, for example, metrology metrics (e.g., overlay, a critical dimension, a reconstruction of a three dimensional profile of features of a substrate, a dose or focus of a lithography apparatus at a moment when the features of the substrate were printed with the lithography apparatus, etc.), manufacturing process parameters (e.g., edge placements, aerial image intensity slopes, sub resolution assist features (SRAF), etc.), and/or other information which can then be used to determine whether an intended or target design has been achieved. The intended design is generally defined as a pre-optical proximity correction design layout which can be provided in a standardized digital file format such as GDSII, OASIS or another file format.

Various optimization methods may be used for achieving pattern fidelity. Simulation and/or modeling can be used to determine one or more metrology metrics (e.g., performing overlay and/or other metrology measurements), configure one or more features of the patterning device pattern (e.g., performing optical proximity correction (OPC)), configure one or more features of the illumination (e.g., changing one or more characteristics of a spatial / angular intensity distribution of the illumination, such as change a shape), configure one or more features of the projection optics (e.g., numerical aperture, etc.), and/or for other purposes. Such determination and/or configuration can be generally referred to as mask optimization, source optimization, and/or projection optimization, for example. Such optimizations can be performed on their own, or combined in different combinations. One such example is source-mask optimization (SMO), which involves the configuring of one or more features of the patterning device pattern (e.g., OPC) together with one or more features of the illumination. The optimizations may use the parameterized model described herein to predict values of various parameters (including images, etc.), for example.

In some embodiments, OPC is a photolithography enhancement technique used to compensate for image errors due to diffraction or process effects. The OPC process configures features of a pattern to correct errors (e.g., irregularities such as line widths that are narrower or wider than designed, distortions such as rounded comers, etc.) caused due to the limitations of light. For example, the OPC process may move edges or add extra polygons to the pattern written on the mask. OPC may be implemented in various ways, e.g., using rule based OPC which is be driven by pre-computed look-up tables based on width and spacing between features, or using simulation models that dynamically simulate the final pattern for a given mask pattern. The objective is to reproduce on the semiconductor wafer, as well as possible, the original layout drawn by the designer.

In some embodiments, SMO is an optimization process in which one or more features of the illumination, such as source radiation intensity, pupil fill ratio (e.g., namely percentage of radiation of the source that passes through a pupil or aperture), magnitude and phase of diffraction orders, etc. are optimized along with one or more features of the mask pattern (e.g., OPC.)

In some embodiments, an optimization process of a system may be represented as a cost function. The optimization process may comprise finding a set of parameters (design variables, process variables, inspection operation variables, etc.) of the system that minimizes the cost function. The term "design variables" as used herein comprises a set of parameters of a lithographic projection apparatus or a lithographic process, for example, parameters a user of the lithographic projection apparatus can adjust, or image characteristics a user can adjust by adjusting those parameters. It should be appreciated that any characteristics of a lithographic projection process, including those of the source, the patterning device, the projection optics, or resist characteristics can be among the design variables in the optimization. The cost function can have any suitable form depending on the goal of the optimization. For example, the cost function can be weighted root mean square (RMS) of deviations of certain characteristics (evaluation points) of the system with respect to the intended values (e.g., ideal values) of these characteristics. The cost function may often be a non-linear function of the design variables. Then standard optimization techniques may be used to minimize the cost function.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

## Claims

1. A method of configuring a lithographic apparatus comprising illuminator optics for directing at least a portion of a radiation beam to an illumination region of a patterning device so as to impart a pattern to the radiation beam and form a patterned radiation beam, the method comprising:
configuring the illuminator optics such that at least two different portions of the patterning device, differing at least in position along a scanning direction of said illumination region, receive radiation from different regions within a pupil plane associated with the illuminator optics.

2. The method of claim 1 further comprising:
receiving, at a first portion of the illumination region, radiation having a first angular distribution and receiving, at a second portion of the illumination region radiation having a second angular distribution; wherein the first portion and the second portion are separated in a scanning direction.

3. The method of claim 2, further comprising receiving radiation such that the first angular distribution and the second angular distribution overlap at a third portion of the illumination region.

4. The method of claim 3, where an angular distribution and area at the third portion is adjustable based on adjustment of the first angular distribution and/or the second angular distribution.

5. The method of claim 2, wherein an alignment of an aerial image associated with a feature on the patterning device depends on a coordinate of the radiation beam in said pupil plane and the method further comprises correcting an aerial image displacement associated with a difference between the portions of the illumination regions.

6. The method of claim 5, wherein the aerial alignment displacement is caused by mask 3D effects.

7. The method of claim 1, wherein said first and second angular distributions correspond to monopoles, wherein the full angular distribution is a y-dipole, and wherein a feature to be illuminated on the patterning device comprises vertical lines.

8. The method of claim 1, further comprising:
projecting the patterned radiation beam onto a target region of a substrate;
determining or predicting an image offset at a substrate level; and
determining an angular distribution of radiation in the illumination region based on the determined or predicted image offset, wherein the angular distribution corresponds to a telecentric offset in the illumination region.

9. The method of claim 8, wherein the predicted image offset is associated with a local tilt of the substrate.

10. The method of claim 5, wherein the aerial alignment displacement is caused by an aberration variation along the scanning direction.

11. The method of claim 6, further comprising inducing an aberration variation along the scanning direction in dependence of the aerial image displacement and the configuring of the illuminator optics.

12. The method of claim 2, wherein a focal position of an aerial image associated with a feature on the patterning device depends on a coordinate of the radiation beam in said pupil plane and the method further comprises homogenizing the aerial image based on a difference in focal positions between the portions of the illumination region.

13. The method of claim 1, wherein each of the different portions comprises a plurality of features which are positioned such that corresponding positions on a substrate of each feature out of the plurality of features are nominally equal between said different portions when the different portions are provided to the same region on said substrate by said lithographic apparatus when used in a double-exposure setting.

14. A computer program comprising program instructions operable to perform the method of any of claims 1 to 13, when run on a suitable apparatus.

15. A non-transient computer program carrier comprising the computer program of claim 14.
